# EUROPEAN PATENT APPLICATION

(11) **EP 4 675 350 A1**
(43) Date of publication of application: **07.01.2026**
(21) Application number: 23957610.1
(22) Date of filing: 31.10.2023
(51) Int. Cl.: G03F 7/004, G03F 7/033

(54) **PHOTOSENSITIVE ELEMENT, METHOD FOR FORMING RESIST PATTERN, AND METHOD FOR MANUFACTURING PRINTED WIRING BOARD**

(71) Applicant: Resonac Corporation, Tokyo 105-7325 (JP)
(72) Inventor: TODA, Natsuki, Tokyo 105-7325 (JP); SAWAKI, Taku, Tokyo 105-7325 (JP); YOSHIHARA, Kensuke, Tokyo 105-7325 (JP); KAGUCHI, Yosuke, Tokyo 105-7325 (JP); ONO, Hiroshi, Tokyo 105-7325 (JP)
(74) Representative: Hoffmann Eitle
(86) International application number: PCT/JP2023/039303
(87) International publication number: WO 2025/094282

(57) **Abstract**

A photosensitive element according to the present disclosure is a photosensitive element including a support, and a photosensitive layer formed on the support using a photosensitive resin composition, in which the photosensitive layer has a thickness of 10 µm or less, the photosensitive layer contains a binder polymer, a photopolymerizable compound, a photopolymerization initiator, and a sensitizer, the binder polymer has a first structural unit derived from acrylic acid, and the binder polymer has an acid value of 140 to 165 mg KOH/g.

## Description

### Technical Field

The present disclosure relates to a photosensitive element, a method for forming a resist pattern, and a method for producing a printed wiring board.

### Background Art

In the field of printed wiring board production, photosensitive resin compositions as resist materials used for an etching treatment, a plating treatment, or the like, and photosensitive elements including a layer formed on a support film using a photosensitive resin composition (hereinafter, also referred to as "photosensitive layer") are widely used (see, for example, Patent Literature 1).

A printed wiring board is produced using the above-described photosensitive element, for example, by the following procedure. That is, first, a photosensitive layer of a photosensitive element is laminated on a substrate for circuit formation such as a copper-clad laminated plate. Next, the photosensitive layer is exposed to light through a mask film or the like, and a photocured part is formed. At this time, the support film is peeled before the exposure or after the exposure. Thereafter, regions other than the photocured parts in the photosensitive layer are removed using a developing solution, and a resist pattern is formed. Next, the resist pattern is used as a resist and is subjected to an etching treatment or a plating treatment to form a conductor pattern, and finally the photocured parts (resist pattern) of the photosensitive layer are stripped (removed).

### Citation List

### Patent Literature

Patent Literature 1: JP 2013-195712 A

### Summary of Invention

### Technical Problem

Along with miniaturization and performance improvement of devices and modules in recent years, semiconductor packages are required to have fine wiring formed thereon at high densities. Accordingly, it is preferable that a photosensitive resin composition forms a finer resist pattern in which the line width and the space width are both 5 µm or less, and more preferably the line width and the space width are both 2 µm or less. In order to form a finer resist pattern, it is necessary to further improve the developability and resolution of the photosensitive layer.

It is an object of the present disclosure to provide a photosensitive element with which a finer resist pattern having excellent developability and resolution can be formed, and a method for forming a resist pattern and a method for producing a printed wiring board.

### Solution to Problem

An aspect of the present disclosure relates to the following photosensitive element, method for forming a resist pattern, and method for producing a printed wiring board.
[1] A photosensitive element comprising a support and a photosensitive layer formed on the support using a photosensitive resin composition, wherein the photosensitive layer has a thickness of 10 µm or less, the photosensitive layer comprises a binder polymer, a photopolymerizable compound, a photopolymerization initiator, and a sensitizer, the binder polymer has a first structural unit derived from acrylic acid, and the binder polymer has an acid value of 140 to 165 mg KOH/g.
[2] The photosensitive element according to the above-described [1], wherein the binder polymer has an acid value of 145 to 160 mg KOH/g.
[3] A photosensitive element comprising a support and a photosensitive layer formed on the support using a photosensitive resin composition, wherein the photosensitive layer has a thickness of 10 µm or less, the photosensitive layer comprises a binder polymer, a photopolymerizable compound, a photopolymerization initiator, and a sensitizer, the binder polymer has a first structural unit derived from acrylic acid and a second structural unit derived from styrene or a styrene derivative, and based on a total mass of structural units derived from polymerizable monomers constituting the binder polymer, a content of the first structural unit is 18.0% to 22.0% by mass, and a content of the second structural unit is 60.0% by mass or more.
[4] The photosensitive element according to the above-described [3], wherein the binder polymer further has a third structural unit derived from a (meth)acrylate compound having an alicyclic structure.
[5] The photosensitive element according to any one of the above-described [1] to [4], wherein the binder polymer has a weight average molecular weight of 30000 to 48000.
[6] The photosensitive element according to any one of the above-described [1] to [5], wherein the photosensitive layer further comprises an ultraviolet absorber.
[7] A method for forming a resist pattern, the method comprising a step of forming a photosensitive layer on a substrate by using the photosensitive element according to any one of the above-described [1] to [6]; a step of irradiating at least a portion of the photosensitive layer with active light rays to form a photocured part; and a step of removing a non-photocured part of the photosensitive layer from the substrate to form a resist pattern.
[8] A method for producing a printed wiring board, the method comprising a step of subjecting a substrate on which a resist pattern has been formed by the method for forming a resist pattern according to the above-described [7], to an etching treatment or a plating treatment to form a conductor pattern.
[9] The method for producing a printed wiring board according to the above-described [8], further comprising a step of removing the resist pattern after the etching treatment or the plating treatment.

### Advantageous Effects of Invention

According to the present disclosure, a photosensitive element which has excellent developability and resolution and on which a finer resist pattern can be formed, a method for forming a resist pattern, and a method for producing a printed wiring board can be provided.

### Brief Description of Drawings

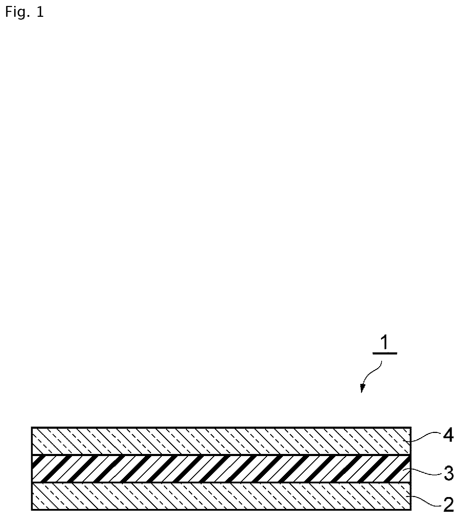

[FIG. 1] FIG. 1 is a schematic cross-sectional view illustrating an embodiment of a photosensitive element.

### Description of Embodiments

According to the present specification, the term "step" refers not only to an independent step, but a step that cannot be clearly distinguished from other steps is also included in the present term as long as the intended action of the step is achieved. The term "layer" includes a structure having a shape formed over the entire surface as well as a structure having a shape formed on a part, when viewed in a plan view. A numerical value range indicated using the term "to" indicates a range including the numerical values described before and after the term "to" as the minimum value and the maximum value, respectively. With regard to a numerical value range described in stages in the present specification, the upper limit value or lower limit value of a numerical value range of a certain stage may be replaced with the upper limit value or lower limit value of a numerical value range of another stage. With regard to a numerical value range described in the present specification, the upper limit value or lower limit value of the numerical value range may be replaced with a value shown in the Examples.

In the present specification, the term "(meth)acrylate" means at least one of "acrylate" and its corresponding "methacrylate". The same also applies to other similar expressions such as "(meth)acryloyl".

In the present specification, the amount of each component in a photosensitive resin composition means, in a case where there are a plurality of substances corresponding to each component in the composition, the total amount of the plurality of substances present in the present composition, unless particularly stated otherwise. In the present specification, the term "solid content" refers to the non-volatile content in the photosensitive resin composition, excluding volatile substances (water, solvent, and the like). That is, the term "solid content" refers to components other than solvents, which do not evaporate during drying of the photosensitive resin composition that will be described below, and also includes components that are liquid, syrup-like, or wax-like at room temperature (25°C).

### [Photosensitive element]

A photosensitive element of the present embodiment includes a support, and a photosensitive layer formed on the support. When using the photosensitive element according to the present embodiment, the photosensitive layer may be laminated on a substrate and then exposed to light without peeling the support (support film).

FIG. 1 is a schematic cross-sectional view of the photosensitive element according to an embodiment. As shown in FIG. 1, the photosensitive element 1 is configured to include a support 2 and a photosensitive layer 3 formed on the support 2, and to further include other layers such as a protective layer 4, which are provided as necessary. Each layer of the photosensitive element according to the present embodiment will be described in detail below.

The support 2 and the protective layer 4 may be each a polymer film having heat resistance and solvent resistance, and may be, for example, a polyester film such as a polyethylene terephthalate film; or a polyolefin film such as a polyethylene film or a polypropylene film. The support 2 and the protective layer 4 may be each a film of a hydrocarbon-based polymer other than a polyolefin. A film of a hydrocarbon-based polymer including a polyolefin may have a low density and for example, may have a density of 1.014 g/cm³ or less. The support 2 and the protective layer 4 may be each a stretched film obtained by stretching the low-density hydrocarbon-based polymer film. The type of the polymer film constituting the protective layer 4 may be the same as or different from the type of the polymer film constituting the support 2.

These polymer films can be purchased as, for example, polyethylene terephthalate films such as PS series (for example, PS-25) manufactured by Teijin, Ltd., polyethylene films such as NF-15 manufactured by Tamapoly Co., Ltd., or polypropylene films manufactured by Oji Paper Co., Ltd. (for example, ALPHAN MA-410 and E-200C) and Shin-Etsu Film Co., Ltd., respectively.

From the viewpoint that damage to the support 2 can be suppressed when the support 2 is peeled from the photosensitive layer 3, the thickness of the support 2 may be 1 µm or more or 5 µm or more, and from the viewpoint that exposure can be suitably achieved when exposure is performed through the support 2, the thickness may be 100 µm or less, 50 µm or less, or 30 µm or less.

From the viewpoint that damage to the protective layer 4 can be suppressed when the photosensitive layer 3 and the support 2 are laminated on a substrate while peeling the protective layer 4, the thickness of the protective layer 4 may be 1 µm or more, 5 µm or more, or 15 µm or more, and from the viewpoint that productivity is improved, the thickness may be 100 µm or less, 50 µm or less, or 30 µm or less.

From the viewpoint of forming a fine resist pattern, the thickness of the photosensitive layer 3 is 10 µm or less. From the viewpoint that coating is easily achieved and productivity is improved, the thickness of the photosensitive layer 3 after drying (in a case where the photosensitive resin composition contains an organic solvent, after the organic solvent is volatilized) may be 1 µm or more, 2 µm or more, 3 µm or more, 4 µm or more, or 5 µm or more, and from the viewpoint of further improving the resolution, the thickness after drying may be 9 µm or less, 8 µm or less, or 7 µm or less.

The photosensitive layer 3 is a layer formed using the photosensitive resin composition that will be described below, and contains a binder polymer, a photopolymerizable compound, a photopolymerization initiator, and a sensitizer. The photosensitive layer 3 may contain a polymerization inhibitor, an ultraviolet absorber, or other components as necessary. Hereafter, each component used in the photosensitive resin composition according to the present embodiment will be described in more detail.

### (Component (A): Binder polymer)

Since the photosensitive resin composition according to the present embodiment contains a binder polymer having a specific structure as component (A), the photosensitive resin composition can improve the developability and resolution of the photosensitive layer that is formed from the photosensitive resin composition.

The binder polymer according to the present embodiment may have a first structural unit derived from acrylic acid, and the acid value of the binder polymer may be 140 to 165 mg KOH/g. Furthermore, the binder polymer according to the present embodiment may have a first structural unit derived from acrylic acid and a second structural unit derived from styrene or a styrene derivative, and the content of the first structural unit based on the total mass of the structural units derived from polymerizable monomers constituting the binder polymer may be 18.0% to 22.0% by mass, while the content of the second structural unit may be 60.0% by mass or more.

The component (A) can be produced by subjecting a polymerizable monomer containing acrylic acid to radical polymerization. As the component (A) has a first structural unit derived from acrylic acid, the alkali developability of the photosensitive resin composition can be improved.

From the viewpoint of further shortening the developing time, the content of the first structural unit in the component (A) may be 18.0% by mass or more, 18.5% by mass or more, 19.0% by mass or more, or 19.5% by mass or more, based on (100% by mass) the total mass of the structural units derived from polymerizable monomers constituting the binder polymer. From the viewpoint of further improving the resolution, the content of the first structural unit may be 22.0% by mass or less, 21.5% by mass or less, or 21.0% by mass or less. From the viewpoint of improving the developability and resolution in a well-balanced manner, the content of the first structural unit may be 18.0% to 22.0% by mass, 18.5% to 22.0% by mass, 19.0% to 21.5% by mass, or 19.5% to 21.0% by mass.

As the component (A) has a second structural unit derived from styrene or a styrene derivative, the resolution and adhesiveness of the photosensitive resin composition can be improved. Examples of the styrene derivative include vinyltoluene, α-methylstyrene, p-methylstyrene, and p-ethylstyrene.

From the viewpoint of further improving the adhesiveness, the content of the second structural unit in the component (A) may be 60.0% by mass or more, 64.0% by mass or more, 68.0% by mass or more, or 70.0% by mass or more, based on the total mass of the structural units derived from the polymerizable monomers constituting the binder polymer. From the viewpoint of further shortening the releasing time, the content of the second structural unit may be 85.0% by mass or less, 84.0% by mass or less, 83.0% by mass or less, or 80% by mass or less. From the viewpoint of improving the adhesiveness and releasability in a well-balanced manner, the content of the styrene-based structural unit may be 60.0% to 85.0% by mass, 64.0% to 84.0% by mass, 68.0% to 83.0% by mass, or 70.0% to 80.0% by mass.

As the component (A) has a third structural unit derived from a (meth)acrylate compound having an alicyclic structure, the balance between developability and resolution of the photosensitive resin composition can be adjusted.

Examples of the (meth)acrylate having an alicyclic structure include cyclohexyl (meth)acrylate, isobornyl (meth)acrylate, adamantyl (meth)acrylate, cyclopentanyl (meth)acrylate, and dicyclopentanyl (meth)acrylate.

From the viewpoint of further improving the resolution of the photosensitive resin composition, the content of the third structural unit may be 0.5% by mass or more, 1.0% by mass or more, 2.0% by mass or more, or 3.0% by mass or more, based on the total mass of the structural units derived from the polymerizable monomers constituting the binder polymer, and from the viewpoint of further improving the developability of the photosensitive resin composition, the content of the third structural unit may be 18.0% by mass or less, 15.0% by mass or less, 10.0% by mass or less, or 8.0% by mass or less.

The component (A) may further contain a structural unit derived from a polymerizable monomer other than the above-described ones (hereinafter, also referred to as "other monomer"). Examples of the other monomer include methacrylic acid, 2-ethylhexyl (meth)acrylate, hydroxyethyl (meth)acrylate, benzyl (meth)acrylate or a derivative thereof, furfuryl (meth)acrylate, tetrahydrofurfuryl (meth)acrylate, dimethylaminoethyl (meth)acrylate, diethylaminoethyl (meth)acrylate, glycidyl (meth)acrylate, 2,2,2-trifluoroethyl (meth)acrylate, 2,2,3,3-tetrafluoropropyl (meth)acrylate, β-furyl (meth)acrylic acid, β-styryl (meth)acrylic acid, maleic acid, maleic anhydride, maleic acid monoalkyl ester, fumaric acid, cinnamic acid, α-cyanocinnamic acid, itaconic acid, crotonic acid, and propiolic acid. These can be used singly or in combination of two or more kinds thereof.

The weight average molecular weight (Mw) of the component (A) may be 25000 to 50000, 30000 to 48000, 32000 to 46000, or 35000 to 44000. When the Mw is 50000 or less, the resolution and developability tend to be further improved, and when the Mw is 25000 or more, there is a tendency that chipping and releasing of the resist pattern are less likely to occur. The dispersity (Mw/Mn) of the component (A) may be 1.0 to 3.0, 1.0 to 2.5, or 1.0 to 2.3. When the dispersity becomes smaller, the resolution tends to improve.

The Mw and Mn can be measured, for example, by gel permeation chromatography (GPC) using a calibration curve of polystyrene standards. More specifically, the Mw and Mn can be measured under the conditions described in the Examples.

From the viewpoint of achieving both developability and releasability, the acid value of the component (A) may be 140 to 165 mg KOH/g, 144 to 163 mg KOH/g, 145 to 160 mg KOH/g, or 146 to 158 mg KOH/g. When the acid value of the component (A) is 140 mg KOH/g or more, it is easier to shorten the developing time, and when the acid value is 165 mg KOH/g or less, the resolution is further improved so that a finer resist pattern is likely to be formed. The acid value of the component (A) can be adjusted using the structural unit derived from acrylic acid. The acid value of the component (A) can be measured according to JIS K6901:2008 5.3.2.

From the viewpoint of resolution or adhesiveness, the glass transition temperature (Tg) of the component (A) may be 70°C to 125°C, 90°C to 120°C, 94°C to 110°C, or 96°C to 108°C. The Tg of the component (A) is a value that can be determined by the Fox equation, and can be calculated from the mass of each of the polymerizable monomers constituting the component (A), and the Tg of a homopolymer of each of the polymerizable monomers.

From the viewpoint that the moldability of the film is excellent, the content of the component (A) may be 20 parts by mass or more, 30 parts by mass or more, 40 parts by mass, or 50 parts by mass or more with respect to 100 parts by mass of the total amount of the component (A) and the component (B), and from the viewpoint that sensitivity and resolution are further improved, the content may be 80 parts by mass or less, 70 parts by mass or less, or 60 parts by mass or less.

### (Component (B): Photopolymerizable compound)

The component (B) is not particularly limited as long as it is a compound that has at least one ethylenically unsaturated bond and is capable of photopolymerization. From the viewpoint of improving the alkali developability, the resolution, and the post-curing release property, it is preferable that the component (B) includes at least one bisphenol type (meth)acrylate, and it is more preferable that the component (B) includes bisphenol A type (meth)acrylate among bisphenol type (meth)acrylates.

Examples of the bisphenol A type (meth)acrylate include 2,2-bis(4-((meth)acryloxypolyethoxy)phenyl)propane, 2,2-bis(4-((meth)acryloxypolypropoxy)phenyl)propane, 2,2-bis(4-((meth)acryloxypolybutoxy)phenyl)propane, and 2,2-bis(4-((meth)acryloxypolyethoxypolypropoxy)phenyl)propane. Among them, from the viewpoint of further improving the resolution and the release property, 2,2-bis(4-((meth)acryloxypolyethoxy)phenyl)propane is preferred.

As 2,2-bis(4-((meth)acryloxypolyethoxy)phenyl)propane, a compound in which the number of oxyethylene groups is 10 or greater may be used, a compound in which the number of oxyethylene groups is less than 10 may be used, or a compound in which the number of oxyethylene groups is 10 or more and a compound in which the number of oxyethylene groups is less than 10 may be used in combination.

Examples of commercially available bisphenol A type (meth)acrylate include BPE-200 (manufactured by Shin-Nakamura Chemical Co., Ltd., trade name) as 2,2-bis(4-((meth)acryloxydipropoxy)phenyl)propane, BP-2EM (manufactured by Kyoeisha Chemical Co., Ltd., trade name) as ethoxylated bisphenol A dimethacrylate, and BPE-500 (manufactured by Shin-Nakamura Chemical Co., Ltd., trade name) and FA-321M (manufactured by Resonac Corporation, trade name) as 2,2-bis(4-(methacryloxypentaethoxy)phenyl)propane. These bisphenol A type (meth)acrylates may be used singly or in combination of two or more kinds thereof.

The content of the bisphenol type (meth)acrylate may be 40% to 98% by mass, 50% to 97% by mass, 60% to 95% by mass, or 70% to 90% by mass, based on the total amount of the component (B). When this content is 40% by mass or more, the resolution, adhesiveness, and suppressibility of the resist skirt generation are further improved, and when the content is 98% by mass or less, the developing time is moderately shortened, while the development residue is less likely to be generated.

From the viewpoint that the flexibility of the cured product (cured film) is improved, the component (B) other than a bisphenol type (meth)acrylate may further include at least one polyalkylene glycol di(meth)acrylate having at least one of a (poly)oxyethylene chain and a (poly)oxypropylene chain in the molecule, or may further include a polyalkylene glycol di(meth)acrylate having both a (poly)oxyethylene chain and a (poly)oxypropylene chain in the molecule. The total number of oxyethylene groups (EO groups) and/or oxypropylene groups (PO groups) contained in the polyalkylene glycol di(meth)acrylate may be 2 to 40, 4 to 30, or 6 to 20, from the viewpoint of further improving the adhesiveness and resolution.

Examples of the polyalkylene glycol di(meth)acrylate include FA-023M (manufactured by Resonac Corporation, trade name), FA-024M (manufactured by Resonac Corporation, trade name), and NK ESTER HEMA-9P (manufactured by Shin-Nakamura Chemical Co., Ltd., trade name). These may be used singly or in combination of two or more kinds thereof.

The content of the polyalkylene glycol di(meth)acrylate may be 2% to 40% by mass, 3% to 30% by mass, or 5% to 20% by mass, based on the total amount of the component (B).

As the component (B) other than the above-described compounds, nonylphenoxy polyethyleneoxy acrylate, a phthalic acid-based compound, a (meth)acrylic acid polyol ester, a (meth)acrylic acid alkyl ester, and the like may also be used. Among them, from the viewpoint of improving the resolution, adhesiveness, resist shape, and post-curing release property in a well-balanced manner, the component (B) may include at least one selected from nonylphenoxy polyethyleneoxy acrylate and a phthalic acid-based compound. However, since the refractive indices of these compounds are relatively low, from the viewpoint of improving the resolution, the content thereof may be 5% to 50% by mass, 5% to 40% by mass, or 10% to 30% by mass, based on the total amount of the component (B).

Examples of the nonylphenoxy polyethyleneoxy acrylate include nonylphenoxy triethyleneoxy acrylate, nonylphenoxy tetraethyleneoxy acrylate, nonylphenoxy pentaethyleneoxy acrylate, nonylphenoxy hexaethyleneoxy acrylate, nonylphenoxy heptaethyleneoxy acrylate, nonylphenoxy octaethyleneoxy acrylate, nonylphenoxy nonaethyleneoxy acrylate, nonylphenoxy decaethyleneoxy acrylate, and nonylphenoxy undecaethyleneoxy acrylate.

Examples of the phthalic acid-based compound include γ-chloro-β-hydroxypropyl-β'-(meth)acryloyloxyethyl-o-phthalate, β-hydroxyethyl-β'-(meth)acryloyloxyethyl-o-phthalate, and β-hydroxypropyl-β'-(meth)acryloyloxyethyl-o-phthalate. γ-Chloro-β-hydroxypropyl-β'-methacryloyloxyethyl-o-phthalate is commercially available as FA-MECH (manufactured by Resonac Corporation, trade name).

From the viewpoint of improving the sensitivity and reducing footing trailing, the component (B) may include a (meth)acrylic acid polyol ester. Examples of the (meth)acrylic acid polyol ester include trimethylolpropane polyethoxy tri(meth)acrylate, trimethylolpropane polypropoxy tri(meth)acrylate, trimethylolpropane polybutoxy tri(meth)acrylate, trimethylolpropane polyethoxy polypropoxy tri(meth)acrylate, trimethylolethane polyethoxy tri(meth)acrylate, trimethylolethane polypropoxy tri(meth)acrylate, trimethylolethane polybutoxy tri(meth)acrylate, trimethylolethane polyethoxy polypropoxy tri(meth)acrylate, pentaerythritol polyethoxy tri(meth)acrylate, pentaerythritol polypropoxy tri(meth)acrylate, pentaerythritol polybutoxy tri(meth)acrylate, pentaerythritol polyethoxy polypropoxy tri(meth)acrylate, glyceryl polyethoxy tri(meth)acrylate, glyceryl polypropoxy tri(meth)acrylate, glyceryl polybutoxy tri(meth)acrylate, and glyceryl polyethoxy polypropoxy tri(meth)acrylate.

The content of the component (B) is preferably 20 to 60 parts by mass, more preferably 30 to 55 parts by mass, and even more preferably 35 to 50 parts by mass, with respect to 100 parts by mass of the total amount of the component (A) and the component (B). When the content of the component (B) is in this range, the resolution and adhesiveness of the photosensitive resin composition as well as the photosensitivity and film coatability are further improved.

### (Component (C): Photopolymerization initiator)

The component (C) is not particularly limited as long as it is a component capable of polymerizing the component (B), and can be appropriately selected from those conventionally used photopolymerization initiators.

Examples of the component (C) include hexaarylbiimidazole compounds; aromatic ketone compounds such as benzophenone, 2-benzyl-2-dimethylamino-1-(4-morpholinophenyl)-1-butanone, 2-(dimethylamino)-2-[(4-methylphenyl)methyl]-1-[4-(4-morpholinyl)phenyl]-1-butanone, 4-(2-hydroxyethoxy)phenyl-2-(hydroxy-2-propyl) ketone, and 2-methyl-1-[4-(methylthio)phenyl]-2-morpholinopropanone-1; quinone compounds such as an alkyl anthraquinone; benzoin ether compounds such as a benzoin alkyl ether; benzoin compounds such as benzoin and an alkylbenzoin; benzyl derivatives such as benzyl dimethyl ketal; and phosphine oxide compounds such as bis(2,4,6-trimethylbenzoyl)-phenylphosphine oxide, bis(2,6-dimethylbenzoyl)-2,4,4-trimethyl-pentylphosphine oxide, and (2,4,6-trimethylbenzoyl)ethoxyphenylphosphine oxide.

From the viewpoint of improving the adhesiveness of the photosensitive layer to a smooth substrate, the component (C) may include a hexaarylbiimidazole compound. The aryl group in the hexaarylbiimidazole compound may be a phenyl group or the like. A hydrogen atom bonded to the aryl group in the hexaarylbiimidazole compound may be substituted with a halogen atom (a chlorine atom or the like).

The hexaarylbiimidazole compound may be a 2,4,5-triarylimidazole dimer. Examples of the 2,4,5-triarylimidazole dimer include 2-(o-chlorophenyl)-4,5-diphenylimidazole dimer, 2-(o-chlorophenyl)-4,5-bis(m-methoxyphenyl)imidazole dimer, and 2-(p-methoxyphenyl)-4,5-diphenylimidazole dimer.

The content of the component (C) may be 1.0 to 10 parts by mass, 2.0 to 8.0 parts by mass, 3.0 to 7.0 parts by mass, or 4.0 to 6.0 parts by mass, with respect to 100 parts by mass of the total amount of the component (A) and the component (B). When the content of the component (C) is in this range, it is easy to improve both photosensitivity and resolution in a well-balanced manner.

### ((Component (D): Sensitizer)

The photosensitive resin composition according to the present embodiment can effectively utilize the absorption wavelength of the active light rays used for exposure, by containing the component (D).

Examples of the component (D) include a dialkylaminobenzophenone compound, a pyrazoline compound, an anthracene compound, a coumarin compound, a xanthone compound, a thioxanthone compound, an oxazole compound, a benzoxazole compound, a thiazole compound, a benzothiazole compound, a triazole compound, a stilbene compound, a triazine compound, a thiophene compound, a naphthalimide compound, a triarylamine compound, and an aminoacridine compound. From the viewpoint of further improving the resolution and adhesiveness, the component (D) may include a pyrazoline compound or a dialkylaminobenzophenone compound.

Examples of the pyrazoline compound include 1-(4-methoxyphenyl)-3-styryl-5-phenyl-pyrazoline, 1-phenyl-3-(4-methoxystyryl)-5-(4-methoxyphenyl)-pyrazoline, 1,5-bis-(4-methoxyphenyl)-3-(4-methoxystyryl)-pyrazoline, 1-(4-isopropylphenyl)-3-styryl-5-phenyl-pyrazoline, 1-phenyl-3-(4-isopropylstyryl)-5-(4-isopropylphenyl)-pyrazoline, 1,5-bis-(4-isopropylphenyl)-3-(4-isopropylstyryl)-pyrazoline, 1-(4-methoxyphenyl)-3-(4-tert-butylstyryl)-5-(4-tert-butyl-phenyl)-pyrazoline, 1-(4-tert-butyl-phenyl)-3-(4-methoxystyryl)-5-(4-methoxyphenyl)-pyrazoline, 1-(4-isopropyl-phenyl)-3-(4-tert-butylstyryl)-5-(4-tert-butyl-phenyl)-pyrazoline, 1-(4-tert-butyl-phenyl)-3-(4-isopropylstyryl)-5-(4-isopropyl-phenyl)-pyrazoline, 1-(4-methoxyphenyl)-3-(4-isopropylstyryl)-5-(4-isopropylphenyl)-pyrazoline, 1-(4-isopropyl-phenyl)-3-(4-methoxystyryl)-5-(4-methoxyphenyl)-pyrazoline, 1-phenyl-3-(3,5-dimethoxystyryl)-5-(3,5-dimethoxyphenyl)-pyrazoline, 1-phenyl-3-(3,4-dimethoxystyryl)-5-(3,4-dimethoxyphenyl)-pyrazoline, 1-phenyl-3-(2,6-dimethoxystyryl)-5-(2,6-dimethoxyphenyl)-pyrazoline, 1-phenyl-3-(2,5-dimethoxystyryl)-5-(2,5-dimethoxyphenyl)-pyrazoline, 1-phenyl-3-(2,3-dimethoxystyryl)-5-(2,3-dimethoxyphenyl)-pyrazoline, 1-phenyl-3-(2,4-dimethoxystyryl)-5-(2,4-dimethoxyphenyl)-pyrazoline, 1-(4-methoxyphenyl)-3-(3,5-dimethoxystyryl)-5-(3,5-dimethoxyphenyl)-pyrazoline, 1-(4-methoxyphenyl)-3-(3,4-dimethoxystyryl)-5-(3,4-dimethoxyphenyl)-pyrazoline, 1-(4-methoxyphenyl)-3-(2,6-dimethoxystyryl)-5-(2,6-dimethoxyphenyl)-pyrazoline, 1-(4-methoxyphenyl)-3-(2,5-dimethoxystyryl)-4-(2,5-dimethoxyphenyl)-pyrazoline, 1-(4-methoxyphenyl)-3-(2,3-dimethoxystyryl)-5-(2,3-dimethoxyphenyl)-pyrazoline, 1-(4-methoxyphenyl)-3-(2,4-dimethoxystyryl)-5-(2,4-dimethoxyphenyl)-pyrazoline, 1-(4-tert-butylphenyl)-3-(3,5-dimethoxystyryl)-5-(3,5-dimethoxyphenyl)-pyrazoline, 1-(4-tert-butyl-phenyl)-3-(3,4-dimethoxystyryl)-5-(3,4-dimethoxyphenyl)-pyrazoline, 1-(4-tert-butyl-phenyl)-3-(2,6-dimethoxystyryl)-5-(2,6-dimethoxyphenyl)-pyrazoline, 1-(4-tert-butylphenyl)-3-(2,5-dimethoxystyryl)-5-(2,5-dimethoxyphenyl)-pyrazoline, 1-(4-tert-butyl-phenyl)-3-(2,3-dimethoxystyryl)-5-(2,3-dimethoxyphenyl)-pyrazoline, 1-(4-tert-butyl-phenyl)-3-(2,4-dimethoxystyryl)-5-(2,4-dimethoxyphenyl)-pyrazoline, 1-(4-isopropylphenyl)-3-(3,5-dimethoxystyryl)-5-(3,5-dimethoxyphenyl)-pyrazoline, 1-(4-isopropyl-phenyl)-3-(3,4-dimethoxystyryl)-5-(3,4-dimethoxyphenyl)-pyrazoline, 1-(4-isopropyl-phenyl)-3-(2,6-dimethoxystyryl)-5-(2,6-dimethoxyphenyl)-pyrazoline, 1-(4-isopropylphenyl)-3-(2,5-dimethoxystyryl)-5-(2,5-dimethoxyphenyl)-pyrazoline, 1-(4-isopropyl-phenyl)-3-(2,3-dimethoxystyryl)-5-(2,3-dimethoxyphenyl)-pyrazoline, and 1-(4-isopropyl-phenyl)-3-(2,4-dimethoxystyryl)-5-(2,4-dimethoxyphenyl)-pyrazoline.

Examples of the dialkylaminobenzophenone compound include 4,4'-bis(dimethylamino)benzophenone, 4,4'-bis(diethylamino)benzophenone, and 4-benzoyl-4'-methyldiphenyl sulfide.

From the viewpoint of further improving the adhesiveness, the content of the component (D) may be 1.60 parts by mass or less, 1.50 parts by mass or less, 1.40 parts by mass or less, or 1.35 parts by mass or less, with respect to 100 parts by mass of the component (C). From the viewpoint of improving the developability, adhesiveness, and release property in a well-balanced manner, the content of the component (D) may be 0.15 to 1.60 parts by mass, 0.20 to 1.50 parts by mass, 0.25 to 1.40 parts by mass, or 0.30 to 1.35 parts by mass, with respect to 100 parts by mass of the component (C).

From the viewpoint of improving the photosensitivity and resolution, the content of the component (D) may be 0.01 to 0.10 parts by mass, 0.01 to 0.09 parts by mass, or 0.01 to 0.08 parts by mass, with respect to 100 parts by mass of the total amount of the component (A) and the component (B).

### (Component (E): Polymerization inhibitor)

From the viewpoint of suppressing polymerization at unexposed parts during the formation of a resist pattern and further improving the resolution, the photosensitive resin composition may further contain a polymerization inhibitor as a component (E). Examples of the polymerization inhibitor include 4-tert-butylcatechol and 2,2,6,6-tetramethyl-4-hydroxypiperidine-1-oxyl.

The content of the component (E) may be 0.001 to 0.10 parts by mass, 0.005 to 0.08 parts by mass, or 0.01 to 0.06 parts by mass, with respect to 100 parts by mass of the total amount of the component (A) and the component (B).

### (Component (F): Ultraviolet absorber)

From the viewpoint of forming a finer resist pattern, the photosensitive resin composition may contain an ultraviolet absorber as a component (F).

The component (F) may be a compound that absorbs light in the range of 340 to 430 nm, or may be a compound that efficiently absorbs light having a wavelength of 365 nm. The molar extinction coefficient of the component (F) for light having a wavelength of 365 nm is in the range of 500 to 50000 L/(mol·cm). The molar extinction coefficient is an index of the ease of absorbing light.

When performing exposure of the photosensitive layer using active light rays with a wavelength of 340 to 430 nm, the component (F) effectively absorbs light having the exposure wavelength and therefore may include at least one selected from the group consisting of a benzophenone compound, a benzotriazole compound, and a triazine compound, or may include a benzophenone compound. The benzophenone compound may be a benzophenone compound in which some of hydrogen atoms have been substituted with groups having an oxygen atom, and may be a benzophenone compound having a hydroxy group.

Examples of the benzophenone compound include 4,4'-dimethoxybenzophenone, 4,4'-bis(trimethylacetoxy)benzophenone, 2,4,4'-trihydroxybenzophenone, 2,2',4,4'-tetrahydroxybenzophenone, 2,3,4,4'-tetrahydroxybenzophenone, 2,2',3,4,4'-pentahydroxybenzophenone, 2,4-dihydroxybenzophenone, 2-hydroxy-4-methoxybenzophenone, 2,2'-dihydroxy-4-methoxybenzophenone, 2-hydroxy-4-(octyloxy)benzophenone, and 2-hydroxy-4-methoxybenzophenone-5-sulfonic acid. Examples of the benzotriazole compound include 2,2-methylenebis[6-(2H-benzotriazol-2-yl)-4-tert-octylphenol], 2-(2'-hydroxy-5'-methacryloxyethylphenyl)-2H-benzotriazole, 2-(2H-benzotriazol-2-yl)-4,6-di-tert-pentylphenol, and 2-(5-chloro-2H-benzotriazol-2-yl)-6-tert-butyl-4-methylphenol. Examples of the triazine compound include 2-[4,6-di(2,4-xylyl)-1,3,5-triazin-2-yl]-5-octyloxyphenol, and 2,4,6-tris(2-hydroxy-4-hexyloxy-3-methylphenyl)-1,3,5-triazine.

The content of the component (F) may be 0.05 to 5.0 parts by mass, 0.1 to 4.0 parts by mass, or 0.2 to 2.0 parts by mass, with respect to 100 parts by mass of the total amount of the component (A) and the component (B).

### (Other components)

The photosensitive resin composition may further contain one kind or two or more kinds of other components in addition to the above-mentioned components. Examples of the other components include hydrogen donors (bis[4-(dimethylamino)phenyl]methane, bis[4-(diethylamino)phenyl]methane, Leuco Crystal Violet, N-phenylglycine, and the like), dyes (Malachite Green and the like), tribromophenylsulfone, photochromic agents, thermal color development inhibitors, plasticizers (p-toluenesulfonamide and the like), pigments, fillers, antifoaming agents, flame retardants, stabilizers, adhesion promoters, leveling agents, release promoters, antioxidants, fragrances, imaging agents, and thermal cross-linking agents. The content of the other components may be 0.005 parts by mass or more or 0.01 parts by mass or more, and may be 20 parts by mass or less, with respect to 100 parts by mass of the total amount of the component (A) and the component (B).

The photosensitive resin composition can contain an organic solvent in order to improve handleability of the photosensitive composition, or to regulate the viscosity and storage stability. Regarding the organic solvent, any conventionally used organic solvent can be used without particular limitation. Examples of the organic solvent include methanol, ethanol, acetone, methyl ethyl ketone, methyl cellosolve, ethyl cellosolve, toluene, N,N-dimethylformamide, propylene glycol monomethyl ether, and mixed solvents of these. These can be used singly or in combination of two or more kinds thereof.

The photosensitive element 1 can be obtained, for example, in the following manner. First, a photosensitive layer 3 is formed on a support 2. The photosensitive layer 3 can be formed by, for example, applying a photosensitive resin composition containing an organic solvent to form a coating layer, and drying this coating layer. Next, a protective layer 4 is formed on a surface of the photosensitive layer 3 on the opposite side of the support 2.

The coating layer is formed by, for example, a known method such as roll coating, comma coating, gravure coating, air knife coating, die coating, or bar coating. Drying of the coating layer is carried out such that the amount of the organic solvent remaining in the photosensitive layer 3 is, for example, 2% by mass or less, and specifically, drying is carried out, for example, at 70°C to 150°C for 5 to 30 minutes.

The photosensitive element may further include an intermediate layer between the above-described support 2 and the photosensitive layer 3. The intermediate layer may be a layer containing a water-soluble resin. Examples of the water-soluble resin include resins containing polyvinyl alcohol as a main component.

According to another embodiment, the photosensitive element does not have to include a protective layer, and may further include other layers such as a cushion layer, an adhesive layer, a light absorbing layer, and a gas barrier layer.

The photosensitive element 1 may be, for example, in a sheet form, or may be in the form of a photosensitive element roll wound in a roll form around a core. With regard to the photosensitive element roll, the photosensitive element 1 is preferably wound such that the support 2 is on the outside. The core is formed from, for example, polyethylene, polypropylene, polystyrene, polyvinyl chloride, or an acrylonitrile-butadiene-styrene copolymer. From the viewpoint of protecting end faces, an end face separator may be provided on the end faces of the photosensitive element roll, and from the viewpoint of edge fusion resistance, a moisture-proof end face separator may be provided. The photosensitive element 1 may be wrapped in, for example, a black sheet with low moisture permeability.

The photosensitive element 1 can be suitably used for forming a resist pattern, and can be especially suitably used in the method for producing a printed wiring board that will be described below.

### [Method for forming resist pattern]

A method for forming a resist pattern of the present embodiment includes: a step of forming a photosensitive layer on a substrate using the above-described photosensitive element (photosensitive layer forming step); a step of irradiating at least a portion (predetermined portion) of the above-described photosensitive layer with active light rays to form a photocured part (exposure step); and a step of removing at least a portion of the above-described non-photocured part from the above-described substrate (development step), and the method may also be configured to include other steps. A resist pattern can be referred to as a photocured product pattern of a photosensitive resin composition and can also be referred to as a relief pattern. The method for forming a resist pattern can also be referred to as a method for producing a resist pattern-attached substrate.

### (Photosensitive layer forming step)

Regarding a method for forming a photosensitive layer on a substrate, the protective layer is removed from the above-described photosensitive element, and then the photosensitive layer of the photosensitive element may be pressure-bonded onto the above-described substrate while heating. When a photosensitive element is used, a laminate composed of a substrate, a photosensitive layer, and a support, in which these are laminated in this order, is obtained. The above-described substrate is not particularly limited; however, usually, a substrate for circuit formation including an insulating layer and a conductor layer formed on the insulating layer, or a die pad (base material for a lead frame) such as an alloy base material is used.

It is preferable that the photosensitive layer forming step is carried out under reduced pressure in view of adhesiveness and followability. Heating of the photosensitive layer and/or the substrate at the time of pressure-bonding may be carried out at a temperature of 70°C to 130°C. Pressure-bonding may be carried out at a pressure of about 0.1 to 1.0 MPa (about 1 to 10 kgf/cm²); however, these conditions are appropriately selected as necessary. Incidentally, when the photosensitive layer is heated to 70°C to 130°C, it is not necessary to subject the substrate to a preheating treatment in advance; however, in order to further improve adhesiveness and followability, a preheating treatment of the substrate can be carried out.

### (Exposure step)

In the exposure step, at least a portion of the photosensitive layer formed on the substrate is irradiated with active light rays, thereby photocuring the irradiated portion with active light rays to form a latent image. At this time, in a case where a support is present on the photosensitive layer, when the support is transparent to active light rays, the active light rays can be irradiated through the support; however, when the support is opaque, the photosensitive layer is irradiated with active light rays after the support is removed.

Regarding the exposure method, a method of irradiating active light rays in an image-wise manner through a negative or positive mask pattern called artwork (mask exposure method) may be mentioned. Furthermore, a method of irradiating active light rays in an image-wise manner by a projection exposure method may also be employed. Furthermore, a method of irradiating active light rays in an image-wise manner by a direct writing exposure method such as an LDI (Laser Direct Imaging) exposure method or a DLP (Digital Light Processing) exposure method may also be employed.

As the light source for the active light rays, any known light source can be used, and for example, light sources that effectively emit ultraviolet radiation and visible light, such as a carbon arc lamp, a mercury vapor arc lamp, a high-pressure mercury lamp, a xenon lamp, a gas laser such as an argon laser, a solid-state laser such as a YAG laser, and a semiconductor laser, are used.

### (Development step)

In the development step, as at least a portion of a non-photocured part (other than a photocured part) of the above-described photosensitive layer is removed from the substrate, a resist pattern is formed on the substrate. In a case where a support is present on the photosensitive layer, removal (development) of a region other than the above-described photocured part (may also be referred to as an unexposed portion) is carried out after the support is removed. Development methods include wet development and dry development; however, wet development is widely used.

In the case of wet development, development is carried out by a known wet development method using a developing solution suitable for the photosensitive resin composition. Examples of the development method include methods using a dipping method, a paddle method, a spray method, and methods using brushing, scrubbing, rocking immersion, and the like. From the viewpoint of improving the resolution, a high-pressure spray method may be used as the development method. Two or more kinds of these methods may be used in combination to perform development.

The configuration of the developing solution is appropriately selected according to the configuration of the above-described photosensitive resin composition. Examples of the developing solution include an alkaline aqueous solution and an organic solvent developing solution.

From the standpoint of safety, stability, and satisfactory operability, an alkaline aqueous solution may be used as the developing solution. As the base of the alkaline aqueous solution, an alkali hydroxide such as hydroxides of lithium, sodium, or potassium; an alkali carbonate such as carbonate or bicarbonate of lithium, sodium, potassium, or ammonium; an alkali metal phosphate such as potassium phosphate or sodium phosphate; an alkali metal pyrophosphate such as sodium pyrophosphate or potassium pyrophosphate; sodium borate, sodium metasilicate, tetramethylammonium hydroxide, ethanolamine, ethylenediamine, diethylenetriamine, 2-amino-2-hydroxymethyl-1,3-propanediol, 1,3-diaminopropanol-2, morpholine, and the like are used.

As the alkaline aqueous solution used for development, a dilute solution of 0.1% to 5% by mass of sodium carbonate, a dilute solution of 0.1% to 5% by mass of potassium carbonate, a dilute solution of 0.1% to 5% by mass of sodium hydroxide, a dilute solution of 0.1% to 5% by mass of sodium tetraborate, and the like can be used. The pH of the alkaline aqueous solution may be in the range of 9 to 11, and the temperature can be regulated in accordance with the alkali developability of the photosensitive layer. In the alkaline aqueous solution, for example, a surface active agent, an antifoaming agent, a small amount of an organic solvent for promoting development, and the like may be incorporated.

Examples of the organic solvent used for the alkaline aqueous solution include acetone, ethyl acetate, an alkoxyethanol having an alkoxy group having 1 to 4 carbon atoms, ethyl alcohol, isopropyl alcohol, butyl alcohol, diethylene glycol monomethyl ether, diethylene glycol monoethyl ether, and diethylene glycol monobutyl ether.

Examples of the organic solvent used for the organic solvent developing solution include 1,1,1-trichloroethane, N-methyl-2-pyrrolidone, N,N-dimethylformamide, cyclohexanone, methyl isobutyl ketone, and γ-butyrolactone. From the viewpoint of preventing ignition, these organic solvents may be used as organic solvent developing solutions by adding water in an amount in the range of 1% to 20% by mass.

The method for forming a resist pattern according to the present embodiment may include, after removing uncured portions in the development step, a step of further curing the resist pattern by performing heating at about 60°C to 250°C or exposure at a dose of about 0.2 to 10 J/cm² as necessary.

### [Method for producing printed wiring board]

A method for producing a printed wiring board of the present embodiment includes a step of subjecting a substrate on which a resist pattern has been formed by the above-described method for forming a resist pattern, to an etching treatment or a plating treatment to form a conductor pattern, and may be configured to include other steps such as a resist pattern removal step as necessary.

In the plating treatment, the conductor layer provided on the substrate is subjected to a plating treatment by using the resist pattern formed on the substrate as a mask. After the plating treatment, the resist is removed by removing the resist pattern that will be described below, and the conductor layer covered by the resist may be further etched to form a conductor pattern. The method for the plating treatment may be an electrolytic plating treatment or an electroless plating treatment, and the method may be an electroless plating treatment.

In the etching treatment, the conductor layer provided on the substrate is removed by etching using the resist pattern formed on the substrate as a mask, and a conductor pattern is formed. The method for the etching treatment is appropriately selected depending on the conductor layer to be removed. Examples of the etching solution include a cupric chloride solution, a ferric chloride solution, an alkali etching solution, and a hydrogen peroxide-based etching solution.

After the etching treatment or plating treatment, the resist pattern on the substrate may be removed. For the removal of the resist pattern, for example, the resist pattern can be released by using a more strongly alkaline aqueous solution than the above-described alkaline aqueous solution used for the development step. As the strongly alkaline aqueous solution, for example, a 1% to 10% by mass aqueous solution of sodium hydroxide or a 1% to 10% by mass aqueous solution of potassium hydroxide is used.

In a case where the resist pattern is removed after applying a plating treatment, a desired printed wiring board can be produced by further etching the conductor layer covered with the resist through an etching treatment and forming a conductor pattern. The method for the etching treatment at this time is appropriately selected depending on the conductor layer to be removed. For example, the above-mentioned etching solution can be applied.

The method for producing a printed wiring board according to the present embodiment can be applied to the production of single-layer printed wiring boards as well as multilayer printed wiring boards, and can also be applied to the production of printed wiring boards having small diameter through-holes.

### EXAMPLES

Hereinafter, the present disclosure will be more specifically described by way of Examples; however, the present invention is not intended to be limited to these Examples.

### (Component (A): Binder polymer)

Acrylic acid (AA), methacrylic acid (MAA), styrene (ST), and dicyclopentanyl methacrylate (TCDMA) were prepared as polymerizable monomers, and solutions of binder polymers (A-1) to (A-7) shown in Table 1 were produced by the following procedure.

### (A-1)

91.3 g of acrylic acid (AA), 314.5 g of styrene (ST), and 9.4 g of dicyclopentanyl methacrylate (TCDMA) (mass ratio of AA/ST/TCDMA = 21.0/72.2/6.8), 4.6 g of tert-butylperoxy-2-ethyl hexanoate (manufactured by NOF Corporation, trade name "PERBUTYL (registered trademark) O" as a thermal radical polymerization initiator, and 128.6 g of propylene glycol monomethyl ether as a solvent were mixed to prepare a mixture (x). 4.4 g of PERBUTYL O was dissolved in 37.4 g of propylene glycol monomethyl ether to prepare a solution (a).

In a flask equipped with a stirring device, a dropping funnel, a condenser, a thermometer, and a gas inlet tube, 46.2 g of propylene glycol monomethyl ether and 174.8 g of toluene were placed and stirred in a nitrogen atmosphere while replacing with gas, and the temperature was raised to 98°C. Next, the mixture (x) was added dropwise into the flask over 2 hours. After the dropping was completed, the mixture was stirred at 98°C for 2 hours, subsequently the solution (a) was added thereto, and the resulting mixture was further stirred for 3 hours. Next, while continuing stirring, the solution in the flask was heated up to 105°C over 20 minutes, and then stirred at 105°C for 2 hours. Next, 93.8 g of propylene glycol monomethyl ether and 74.2 g of toluene were added thereto, and the mixture was cooled to room temperature while being stirred, to obtain a solution of binder polymer (A-1).

### (A-2) to (A-7)

Solutions of binder polymers (A-2) to (A-7) were obtained in the same manner as in the process of obtaining the solution of binder polymer (A-1), except that the mixture (x) was prepared using the polymerizable monomers shown in Table 1 at the mass ratio shown in the same table.

### (Weight average molecular weight)

As a sample for Mw measurement, the binder polymer solution was dissolved in tetrahydrofuran (THF) to prepare a 0.2% by mass THF solution. The Mw was derived by measurement according to a gel permeation chromatography (GPC) method and calculation using a calibration curve of polystyrene standards. The conditions for GPC are shown below.
Measuring apparatus: SHODEX GPC-101 (manufactured by Resonac Corporation)
Detector: Differential refractometer SHODEX RI-71S (manufactured by Resonac Corporation)
Column: SHODEX LF-804+LF-804 (manufactured by Resonac Corporation)
Column temperature: 40°C
Eluent: Tetrahydrofuran (THF)
Flow rate: 1 mL/min

### (Acid value)

According to JIS K6901:2008 5.3.2, the acid value of the binder polymer was measured by a neutralization titration method.

**[Table 1]**

| | A-1 | A-2 | A-3 | A-4 | A-5 | A-6 | A-7 |
|---|---|---|---|---|---|---|---|
| AA | 21.0 | 20.1 | 19.7 | 20.0 | 22.9 | 17.7 | - |
| MAA | - | - | - | - | - | - | 27.3 |
| ST | 72.2 | 73.2 | 73.7 | 80.0 | 72.2 | 71.5 | 66.0 |
| TCDMA | 6.8 | 6.7 | 6.7 | - | 6.8 | 10.8 | 6.7 |
| Mw | 40500 | 38700 | 39000 | 37700 | 39800 | 40000 | 35650 |
| Acid value (mgKOH/g) | 156 | 153 | 146 | 149 | 173 | 135 | 172 |

### [Photosensitive resin composition]

Photosensitive resin compositions of Examples and Comparative Examples were prepared by mixing each component in the blending amount (parts by mass) shown in Table 2 with 57 parts by mass of the solid content of the binder polymer solution. The details of each component shown in Table 2 will be described below.

### (Component (B): Photopolymerizable compound)

FA-321M: 2,2-Bis(4-(methacryloxypentaethoxy)phenyl)propane (manufactured by Resonac Corporation, the number of EO groups: 10 (average value))
FA-024M: PO·EO·PO-modified dimethacrylate (manufactured by Resonac Corporation, number of EO groups: 6 (average value), the number of PO groups: 12 (average value))
BP-2EM: Ethoxylated bisphenol A dimethacrylate (manufactured by Kyoeisha Chemical Co., Ltd., the number of EO groups: 2.6 (average value))

### (Component (C): Photopolymerization initiator)

B-CIM: 2,2'-Bis(2-chlorophenyl)-4,4',5,5'-tetraphenylbiimidazole (manufactured by Hodogaya Chemical Co., Ltd.)

### (Component (D): Sensitizer)

PZ-501D: 1-Phenyl-3-(4-methoxystyryl)-5-(4-methoxyphenyl)pyrazoline (manufactured by Nippon Chemical Works Co., Ltd.)

### (Component (E): Polymerization inhibitor)

Q-TBC-5P: 4-tert-butylcatechol (manufactured by DIC Corporation) LA-7RD: 2,2,6,6-Tetramethyl-4-hydroxypiperidine-1-oxyl (manufactured by ADEKA Corporation)

### (Component (F): Ultraviolet absorber)

SEESORB-106: 2,2'-Dihydroxy-4,4'-dimethoxybenzophenone (Shipro Kasei Kaisha, Ltd.)

### (Adhesion promoter)

SF-808H: Mixture of carboxybenzotriazole, 5-amino-1H-tetrazole, and methoxypropanol (manufactured by Sanwa Kasei Corporation)

### (Photochromic agent)

LCV: Leuco Crystal Violet (manufactured by Yamada Chemical Co., Ltd.)

### (Dye)

MKG: Malachite Green (manufactured by Osaka Organic Chemical Industry, Ltd.)

**[Table 2]**

| | | |
|---|---|---|
| Photopolymerizable compound | FA-321M | 34.5 |
| | FA-024M | 2.5 |
| | BP-2EM | 6.0 |
| Photopolymerization initiator | B-CIM | 5.5 |
| Sensitizer | PZ-501D | 0.027 |
| Ultraviolet absorber | SEESORB-106 | 0.279 |
| Polymerization inhibitor | Q-TBC-5P | 0.04 |
| | LA-7RD | 0.01 |
| Adhesion promoter | SF-808H | 1.0 |
| Photochromic agent | LCV | 0.77 |
| Dye | MKG | 0.05 |
| Solvent | Acetone | 45 |
| | Toluene | 16 |
| | Methanol | 6 |

### [Photosensitive element]

A polyethylene terephthalate film (manufactured by Toray Industries, Inc., trade name "FS-31") having a thickness of 16 µm was prepared as a support. A photosensitive resin composition was applied on the support and then dried for 10 minutes in a hot air convection type dryer at 90°C to form a photosensitive layer having the thickness shown in Table 3. Subsequently, a polyethylene film (manufactured by Tamapoly Co., Ltd., trade name "NF-15A") was laminated as a protective layer on the photosensitive layer, and a photosensitive element in which a support, a photosensitive layer, and a protective layer were laminated was obtained.

### [Laminate]

A substrate obtained by subjecting a silicon wafer to copper sputtering was heated to 80°C, and the photosensitive element was laminated (stacked) on the copper surface of the substrate. Lamination was carried out such that the photosensitive layer of the photosensitive element was in contact with the copper surface of the copper substrate while peeling the protective layer, by using a heating roll at 110°C at a pressure-bonding pressure of 0.4 MPa and a roll speed of 1.0 m/min. As a result, a laminate in which a substrate, a photosensitive layer, and a support were laminated in this order was obtained. The obtained laminate was used as a test piece for the following tests.

### (Minimum developing time)

The support was peeled from the test piece, the photosensitive layer was exposed, and a 1% by mass aqueous solution of sodium carbonate at 30°C was sprayed thereon. The time taken until the photosensitive layer was completely removed was measured as the minimum developing time.

### (Sensitivity)

A Hitachi 41-step tablet was placed on the support of the laminate, and then the photosensitive layer was exposed through the support using a projection exposure apparatus (manufactured by Ushio, Inc., trade name "UX-44101SM") that used an ultrahigh-pressure mercury lamp (365 nm) as a light source, at an exposure dose (amount of irradiated energy) at which the number of remaining steps of the Hitachi 41-step tablet reached 12 steps. The sensitivity (photosensitivity) was evaluated based on the exposure dose (unit: mJ/cm²) at this time. A smaller exposure dose means higher sensitivity.

### (Resolution)

A laminate having, on the support of the test piece, a wiring pattern of a glass chrome type phototool (resolution negative: line width/space width was x/x (x: 1 to 10, unit: µm) as a negative for resolution evaluation was used, and the photosensitive layer was exposed at a predetermined amount of energy by using a projection exposure apparatus (Canon, Inc., trade name "FPA-3000iW") having an ultrahigh-pressure mercury lamp (365 nm) as a light source. After the exposure, the support was peeled, the photosensitive layer was exposed, a 1% by mass aqueous solution of sodium carbonate at 30°C was sprayed thereon for a time twice the minimum developing time, and unexposed portions were removed (development treatment).

After the development treatment, in a resist pattern in which space portions (unexposed portions) had been neatly removed, and line portions (exposed portions) were formed without twisting, meandering, and chipping, the smallest value of line width/space width was found, and thereby the resolution was evaluated. A smaller numerical value means more satisfactory resolution.

**[Table 3]**

| | Binder polymer | Thickness of photosensitive layer (µm) | Sensitivity (mJ/cm²) | Developability (seconds) | Resolution (µm) |
|---|---|---|---|---|---|
| Example 1 | A-1 | 6 | 165 | 6 | 2.0 |
| Example 2 | A-1 | 7 | 168 | 7 | 2.0 |
| Example 3 | A-2 | 6 | 167 | 6 | 1.8 |
| Example 4 | A-3 | 6 | 160 | 6 | 1.7 |
| Example 5 | A-4 | 7 | 151 | 7 | 2.1 |
| Comparative Example 1 | A-5 | 6 | 168 | 6 | 2.5 |
| Comparative Example 2 | A-6 | 6 | 160 | 100< | 5.0< |
| Comparative Example 3 | A-7 | 6 | 163 | 100< | 5.0< |
| Comparative Example 4 | A-1 | 25 | 160 | 100< | 5.0< |

As is clearly seen from Table 3, the photosensitive elements of Examples 1 to 5 had improved developability and resolution, and could form fine resist patterns. On the other hand, the photosensitive element of Comparative Example 1 did not have sufficient resolution, and the photosensitive elements of Comparative Examples 2 to 4 required some time for the development, and could not form fine resist patterns.

### Reference Signs List

1: photosensitive element, 2: support, 3: photosensitive layer, 4: protective layer.

## Claims

1. A photosensitive element comprising:
a support; and
a photosensitive layer formed on the support using a photosensitive resin composition,
wherein the photosensitive layer has a thickness of 10 µm or less,
the photosensitive layer comprises a binder polymer, a photopolymerizable compound, a photopolymerization initiator, and a sensitizer,
the binder polymer has a first structural unit derived from acrylic acid, and
the binder polymer has an acid value of 140 to 165 mg KOH/g.

2. The photosensitive element according to claim 1, wherein the acid value of the binder polymer is 145 to 160 mg KOH/g.

3. A photosensitive element comprising:
a support; and
a photosensitive layer formed on the support using a photosensitive resin composition,
wherein the photosensitive layer has a thickness of 10 µm or less,
the photosensitive layer comprises a binder polymer, a photopolymerizable compound, a photopolymerization initiator, and a sensitizer,
the binder polymer has a first structural unit derived from acrylic acid and a second structural unit derived from styrene or a styrene derivative, and
based on a total mass of structural units derived from polymerizable monomers constituting the binder polymer, a content of the first structural unit is 18.0% to 22.0% by mass, and a content of the second structural unit is 60.0% by mass or more.

4. The photosensitive element according to claim 3, wherein the binder polymer further has a third structural unit derived from a (meth)acrylate compound having an alicyclic structure.

5. The photosensitive element according to any one of claims 1 to 4, wherein the binder polymer has a weight average molecular weight of 30000 to 48000.

6. The photosensitive element according to any one of claims 1 to 5, wherein the photosensitive layer further comprises an ultraviolet absorber.

7. A method for forming a resist pattern, the method comprising:
a step of forming a photosensitive layer on a substrate using the photosensitive element according to any one of claims 1 to 6;
a step of irradiating at least a portion of the photosensitive layer with active light rays to form a photocured part; and
a step of removing a non-photocured part of the photosensitive layer from the substrate to form a resist pattern.

8. A method for producing a printed wiring board, the method comprising:
a step of subjecting a substrate on which a resist pattern has been formed by the method for forming a resist pattern according to claim 7, to an etching treatment or a plating treatment to form a conductor pattern.

9. The method for producing a printed wiring board according to claim 8, further comprising a step of removing the resist pattern after the etching treatment or the plating treatment.
